# EUROPÄISCHE PATENTSCHRIFT

(11) **EP 0 696 161 B1**
(45) Veröffentlichungstag und Bekanntmachung des Hinweises auf die Patenterteilung: **14.01.1998**
(21) Anmeldenummer: 95111685.4
(22) Anmeldetag: 25.07.1995
(51) Int. Cl.: H05K 9/00, H01R 4/64, H01R 13/658

(54) **Anordnung zum Kontaktieren von Gehäuseteilen eines elektrischen Gerätes**
Device for effecting a contact between the housing parts of an electrical device
Dispositif pour réaliser un contact entre les pièces d'un boîtier d'un appareil électrique

(30) Priorität: 01.08.1994 DE 9412375 U
(43) Veröffentlichungstag der Anmeldung: 07.02.1996
(73) Patentinhaber: SIEMENS AKTIENGESELLSCHAFT, 80333 München (DE)
(72) Erfinder: Abele, Rolf, Dipl.-Phys., D-81475 München (DE); Frentzel, Karlheinz, Dr. Phys., D-82269 Kaltenberg (DE); Scheidl, Edith, D-81369 München (DE)

(56) Entgegenhaltungen:
- EP-A- 0 159 407
- DE-C- 4 102 019
- PATENT ABSTRACTS OF JAPAN vol. 7, no. 213 (C-187) 20. September 1983 & JP-A-58 110 648 (TANAKA KIKINZOKU KOGYO KK) 1. Juli 1983
- PATENT ABSTRACTS OF JAPAN vol. 11, no. 99 (E-493) 27. März 1987 & JP-A-61 251 202 (FUJITSU LTD) 8. November 1986
- PATENT ABSTRACTS OF JAPAN vol. 17, no. 230 (E-1361) 11. Mai 1993 & JP-A-04 359 878 (DAIDO STEEL CO LTD) 14. Dezember 1992

## Beschreibung

Die Erfindung bezieht sich auf eine Anordnung zum Kontaktieren von Gehäuseteilen eines elektrischen Gerätes, insbesondere zum elektromagnetischen Abdichten von einem Gerät mit Hochfrequenz führenden Leitungen. wobei die Gehäuseteile aus blankem Metallblech bestehen und wobei zwischen relativ zueinander beweglichen Gehäuseteilen Kontaktfedern angeordnet sind, die zwischen den beiden Gehäuseteilen verspannt sind und diese elektrisch miteinander verbinden.

Eine derartige Anordnung ist z.B. durch EP-A-0573441 bekannt geworden.
Danach bestehen ein Schirmgehäuse und ein Deckel eines Baugruppenträgers aus Aluminium. Dazwischen sind zur elektromagnetischen Abdichtung Kontaktfederstreifen verklemmt.

Nach der EP-A-0500994 (Beschreibungseinleitung) ist es bekannt, solche Streifen aus Edelstahl herzustellen. Da bei solchen Werkstoffpartnern Reiboxydation auftreten kann, ist man dazu übergegangen, die Kontaktflächen
der Federstreifen galvanisch zu behandeln, um den Übergangswiderstand auch über eine höhere Anzahl von Benutzungszyklen niedrig zu halten. Es ist auch möglich, die Gegenkontaktflächen des Gehäuses galvanisch zu behandeln. Aus Gründen des besseren Umweltschutzes ist jedoch derzeit allgemein bestrebt, galvanische Prozesse zu vermeiden.

Der Erfindung liegt die Aufgabe zugrunde, Kontaktwerkstoffe zu finden, die bei
nicht oder wenig erhöhten Kosten gute Kontakteigenschaften über eine hohe Nutzungsdauer aufweisen, ohne das dafür galvanische oder ähnliche umweltrelevante Prozesse erforderlich werden.

Diese Aufgabe wird durch die Erfindung gemäß Anspruch 1 gelöst. Als Edelstahl wird vorzugsweise Stahl mit 17% Chromanteil verwendet, dessen Materialkosten im Bereich der Kosten für Aluminium von gleicher Stabilität liegen. Auf besondere Kontaktschichten kann verzichtet werden. Neusilber ist eine kostengünstiges Kontaktmaterial, das keiner Oberflächenbehandlung bedarf. Die beiden Materialien sind hinsichtlich ihrer Härte optimal aufeinander abgestimmt, was eine gute Kontaktgabe und geringen Abrieb ergibt.

Es hat sich herausgestellt, daß bei dieser Materialkombination keine Reiboxydation auftritt, so daß die Kontaktqualität auch nach einer hohen Anzahl von Benutzungszyklen hinreichend gut ist. Es hat sich ferner herausgestellt, daß selbst bei geringen Kontaktkräften der Übergangswiderstand gering bleibt.

Nach einer vorteilhaften Weiterbildung der Erfindung sind die Kontaktflächen der Gehäuseteile überschliffen. Dabei wird die Walzhaut des Edelstahls mit ihren Passivschichten zumindest teilweise entfernt. Es entsteht eine aufgerauhte Oberfläche mit erhöhtem lokalen Kontaktdruck und verbessertem Übergangswiderstand. Durch die hohe Abriebfestigkeit des Edelstahls in Kombination mit dem weicheren Neusilber bleibt dieser Zustand auch nach einer hohen Anzahl von Kontaktierzyklen erhalten.

Durch das Befetten nach Anspruch 3 werden die Kontaktstellen vor schädlichen Klimaeinflüssen geschützt.

Die Schrankgehäuse nach Anspruch 4 erfordern einer höhere Festigkeit als Gehäuse von Baugruppenträgern, was mit Edelstahl leichter als mit Aluminium erreicht werden kann. Derartige Gehäuse bestanden bisher aus lackierten Blechen mit zusätzlich aufgeschraubten Kontaktschienen für die Kontaktfedern. Die Kontaktgabe zwischen den verschiedenen Gehäuseteilen ist durch die Farbschichten allgemein erschwert.

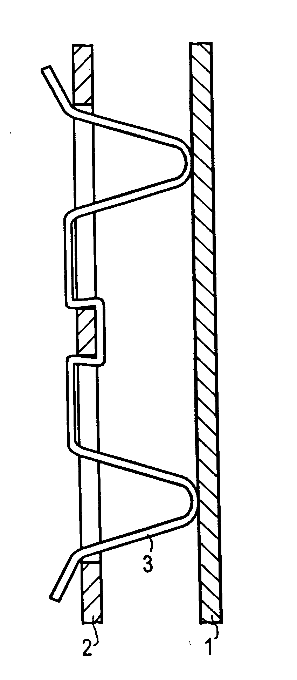

Im folgenden wird die Erfindung anhand eines in der Zeichnung dargestellten Ausführungsbeispieles näher erläutert.

Die dargestellte Figur zeigt schematisiert einen partiellen Schnitt durch ein festes Gehäuseteil 1 und eine bewegliche Schranktür 2 eines Schaltschranks einer telekommunikationstechnischen Vermittlungsanlage. An der Schranktür 2 ist eine Kontakfeder 3 gehalten, die federnd auslenkbare Kontaktkuppen 4 aufweist. Diese sind kontaktgebend gegen das feste Gehäuseteil 2 gedrückt, dessen Oberfläche im Kontaktierbereich überschliffen ist. Es ist üblich, zwischen der Schranktür 2 und dem Gehäuseteil 1 in regelmäßigen Abständen eine Vielzahl der Kontaktfedern 3 zur elektromagnetischen Abdichtung anzuordnen.

Das feste Gehäuseteil 1 und die Schrantür 2 bestehen aus Chromstahl. Die Kontaktfeder ist aus Neusilber hergestellt. Sie läßt sich mit dem überschliffenen Chromstahl des Gehäuse teils besonders gut und dauerhaft kontaktieren.

## Patentansprüche

1. Anordnung zum Kontaktieren von Gehäuseteilen (1,2) eines elektrischen Gerätes, insbesondere zum elektromagnetischen Abdichten eines Gerätes mit Hochfrequenz führenden Leitungen wobei die Gehäuseteile aus blankem Metallblech bestehen und wobei zwischen relativ zueinander beweglichen Gehäuseteilen (1,2) Kontaktfedern (3) angeordnet sind, die zwischen den beiden Gehäuseteilen (1,2) verspannt sind und diese elektrisch miteinander verbinden,
**dadurch gekennzeichnet**,
daß die Gehäuseteile (1,2) aus Edelstahl und die Kontaktfedern aus Neusilber bestehen.

2. Anordnung nach Anspruch 1,
**dadurch gekennzeichnet**,
daß die Kontaktflächen des Gehäuseteiles (1), auf das die Kontaktfedern aufsetzen, überschliffen sind.

3. Anordnung nach Anspruch 1 oder 2,
**dadurch gekennzeichnet**,
daß die Kontaktflächen mit Hochfrequenzfett beschichtet sind.

4. Anordnung nach Anspruch 1,2 oder 3,
**dadurch gekennzeichnet**,
daß die Gehäuseteile (1,2) ein Gehäuse eines Schaltschranks einer Telekommunikationsanlage bilden.

## Claims

1. Arrangement for making contact between housing parts (1, 2) of an electrical device, in particular for the electromagnetic sealing of a device having lines carrying high frequencies, the housing parts comprising shiny metal sheet, and contact springs (3) being arranged between housing parts (1, 2) that can move relative to one another, the said springs (3) being clamped between the two housing parts (1, 2) and connecting the latter electrically, characterized in that the housing parts (1, 2) consist of stainless steel and the contact springs of nickel silver.

2. Arrangement according to Claim 1, characterized in that the contact surfaces of the housing part (1) on which the contact springs are placed are ground.

3. Arrangement according to Claim 1 or 2, characterized in that the contact surfaces are coated with highfrequency grease.

4. Arrangement according to Claim 1, 2 or 3, characterized in that the housing parts (1, 2) form a housing of a switch cabinet of a telecommunications system.

## Revendications

1. Dispositif de mise en contact de pièces (1, 2) de boîtier d'un appareil électrique, notamment pour rendre étanche de manière électromagnétique un appareil ayant des conducteurs haute fréquence, les pièces de boîtier étant en une tôle de métal blanc et des ressorts (3) de contact, qui sont tendus entre les deux pièces (1, 2) de boîtier et qui les relient l'une à l'autre de manière conductrice de l'électricité, étant montés entre des pièces (1, 2) de boîtier mobiles l'une par rapport à l'autre, caractérisé en ce que les pièces (1, 2) de boîtier sont en acier fin et les ressorts de contact en maillechort.

2. Dispositif suivant la revendication 1, caractérisé en ce que les surfaces de contact de la pièce (1) de boîtier sur laquelle repose les ressorts de contact sont polies.

3. Dispositif suivant la revendication 1 ou 2, caractérisé en ce que les surfaces de contact sont revêtues de graisse haute fréquence.

4. Dispositif suivant la revendication 1, 2 ou 3, caractérisé en ce que les pièces (1, 2) de boîtier forment un boîtier d'une armoire de commande d'une installation de communication.
